# EUROPÄISCHE PATENTSCHRIFT

(11) **EP 3 583 689 B1**
(45) Veröffentlichungstag und Bekanntmachung des Hinweises auf die Patenterteilung: **30.12.2020**
(21) Anmeldenummer: 18701431.1
(22) Anmeldetag: 19.01.2018
(51) Int. Cl.: H02M 3/07, H02M 1/08, H02M 1/32, H02H 3/00, H02M 1/36, H02M 1/00, H02H 9/04, H03K 17/06

(54) **VERFAHREN UND SPANNUNGSVERVIELFACHER ZUR WANDLUNG EINER EINGANGSSPANNUNG SOWIE TRENNSCHALTUNG**
METHOD AND VOLTAGE MULTIPLIER FOR CONVERTING AN INPUT VOLTAGE, AND ISOLATING CIRCUIT
PROCÉDÉ ET MULTIPLICATEUR DE TENSION POUR CONVERTIR UNE TENSION D'ENTRÉE ET UN CIRCUIT DE SÉPARATION

(30) Priorität: 14.02.2017 DE 102017202348; 10.03.2017 DE 102017204044
(43) Veröffentlichungstag der Anmeldung: 25.12.2019
(73) Patentinhaber: Ellenberger & Poensgen GmbH, 90518 Altdorf (DE)
(72) Erfinder: BÖSCHE, Dirk, 38536 Seershausen (DE); WILKENING, Ernst-Dieter, 38108 Braunschweig (DE)
(74) Vertreter: FDST Patentanwälte
(86) Internationale Anmeldenummer: PCT/EP2018/051267
(87) Internationale Veröffentlichungsnummer: WO 2018/162133

(56) Entgegenhaltungen:
- EP-A1- 1 544 694
- WO-A1-2016/062427
- DE-A1- 19 638 616
- JP-U- S5 630 590
- US-A1- 2014 268 936

## Beschreibung

Die Erfindung betrifft ein Verfahren zur Wandlung einer Eingangsspannung in eine gegenüber dieser erhöhten Ausgangsspannung. Die Erfindung betrifft weiterhin einen nach einem derartigen Verfahren betriebenen Spannungsvervielfacher sowie eine mit einem derartigen Spannungsvervielfacher ausgestatteten Trennvorrichtung zur Gleichstromunterbrechung zwischen einer Gleichstromquelle und einer elektrischen Einrichtung. Es werden hierbei unter einer Gleichstromquelle insbesondere ein Photovoltaikgenerator (PV-Generator, Solaranlage) und unter einer elektrischen Einrichtung insbesondere ein Wechselrichter verstanden.

Aus der DE 20 2008 010 312 U1 ist eine photovoltaische Anlage (PV-Anlage) mit einem sogenannten Photovoltaikgenerator bekannt, welcher seinerseits aus gruppenweise zu Teilgeneratoren zusammengefassten Photovoltaikmodulen besteht, welche ihrerseits in Reihe geschaltet sind oder in parallelen Strängen vorliegen. Die Gleichstromleistung des Photovoltaikgenerators wird über einen Wechselrichter in ein Wechselspannungsnetz eingespeist. Da eine derartige PV-Anlage oder Solaranlage systembedingt einerseits dauerhaft einen Betriebsstrom und eine Betriebsspannung im Bereich zwischen 180 V (DC) und 1500 V (DC) liefert und andererseits - beispielsweise zu Installations-, Montage- oder Servicezwecken sowie insbesondere auch zum allgemeinen Personenschutz - eine zuverlässige Trennung der elektrischen Komponenten oder Einrichtungen von der als Gleichstromquelle wirksamen PV-Anlage gewünscht ist, muss eine entsprechende Trennvorrichtung in der Lage sein, eine Unterbrechung unter Last, das bedeutet ohne vorheriges Abschalten der Gleichstromquelle, vorzunehmen.

Zum Zwecke einer Lasttrennung kann ein mechanischer Schalter (Schaltkontakt) eingesetzt werden, sodass vorteilhafterweise bei einer erfolgten Kontaktöffnung eine galvanische Trennung der elektrischen Einrichtung (Wechselrichter) von der Gleichstromquelle (PV-Anlage) realisiert ist. Werden im Gegensatz hierzu zur Lasttrennung leistungsfähige Halbleiterschalter eingesetzt, so treten auch im Normalbetrieb unvermeidbare Leistungsverluste an den Halbleiterschaltern auf. Des Weiteren ist mit derartigen Leistungshalbleiterschaltern keine galvanische Trennung und somit kein zuverlässiger Personenschutz realisierbar.

Aus der DE 102 25 259 B3 ist ein als Lasttrenner ausgebildeter elektrischer Steckverbinder bekannt, welcher nach Art eines Hybridschalters ein Halbleiterschalter in Form eines Thyristors im Gehäuse des Wechselrichters sowie Haupt- und Hilfskontakte aufweist, welche mit PV-Modulen verbunden sind. Der bei einem Aussteckvorgang voreilende Hauptkontakt ist dem nacheilenden und mit dem Halbleiterschalter in Reihe geschalteten Hilfkontakt parallel geschaltet. Dabei wird der Halbleiterschalter zu Lichtbogenvermeidung beziehungsweise Lichtbogenlöschung angesteuert, indem dieser periodisch ein- und ausgeschaltet wird.

Zur Gleichstromunterbrechung kann auch ein hybrider elektromagnetischer Gleichstromschalter mit einem elektromagnetisch betätigten Hauptkontakt und mit einem IGBT (insulated gate bipolar transistor) als Halbleiterschalter verwendet werden (DE 103 15 982 A2). Ein derartiger Hybridschalter weist jedoch eine externe Energiequelle zum Betreiben einer Leistungselektronik mit einem Halbleiterschalter auf.

Die WO 2010/108565 A1 beschreibt einen hybriden Trennschalter mit einem mechanischen Schalter oder Trennelement sowie einer diesem parallel geschalteten Halbleiterelektronik, welche im Wesentlichen zumindest einen Halbleiterschalter, vorzugsweise einen IGBT, umfasst. Die Halbleiterelektronik weist hierbei keine zusätzliche Energiequelle auf und ist bei einem geschlossenen mechanischen Schalter stromsperrend, das bedeutet praktisch strom- und spannungslos. Die Halbleiterelektronik gewinnt die zu deren Betreib erforderliche Energie aus der Trennvorrichtung, das heißt aus dem Trennschaltersystem selbst, wobei die Energie des beim Öffnen des mechanischen Schalters entstehenden Lichtbogens genutzt wird. Hierbei ist die Halbleiterelektronik ansteuerseitig derart mit dem mechanischen Schalter verschaltet, dass bei sich öffnendem Schalter die Lichtbogenspannung über dessen Schaltkontakten infolge des Lichtbogens die Halbleiterelektronik stromleitend schaltet.

Sobald die Halbleiterelektronik stromleitend geschaltet ist, beginnt der Lichtbogenstrom von dem mechanischen Schalter auf die Halbleiterelektronik zu kommutieren. Die entsprechende Lichtbogenspannung beziehungsweise der Lichtbogenstrom lädt hierbei einen Energiespeicher in Form eines Kondensators auf, welcher sich unter Erzeugung einer Steuerspannung zum lichtbogenfreien Abschalten der Halbleiterschalter gezielt entlädt. Die vorgegebene Zeitdauer oder Zeitkonstante und somit die Ladedauer des Energiespeichers beziehungsweise Kondensators bestimmt die Lichtbogendauer. Im Anschluss an den Ladevorgang startet ein Zeitglied, während dessen die Halbleiterelektronik lichtbogenfrei stromleitend angesteuert wird. Die Zeitdauer des Zeitglieds ist dabei auf ein sicheres Löschen des Lichtbogens eingestellt.

Problematisch bei derartigen lichtbogengespeisten Hybridschaltern ist, dass die Lichtbogenspannung zunächst einen vorgegebenen Spannungswert erreichen oder überschreiten muss, damit der zumindest eine IGBT der Halbleiterelektronik zum Kurzschließen der Schaltstrecke sicher angesteuert wird. Die für diesen Spannungsanstieg benötigte Zeit bewirkt einen zusätzlichen Verschleiß an den mechanischen (Schalt-)Kontakten.

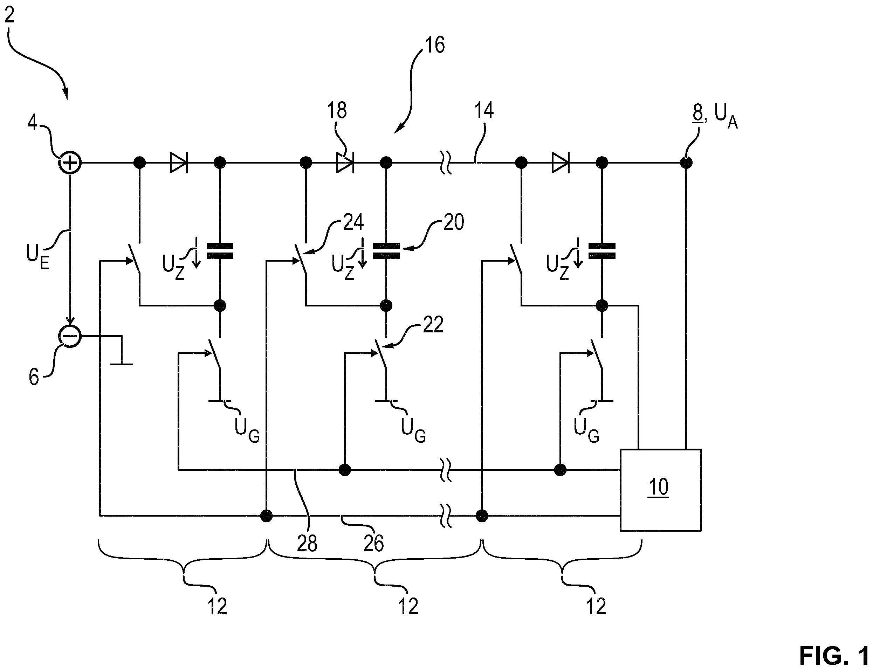

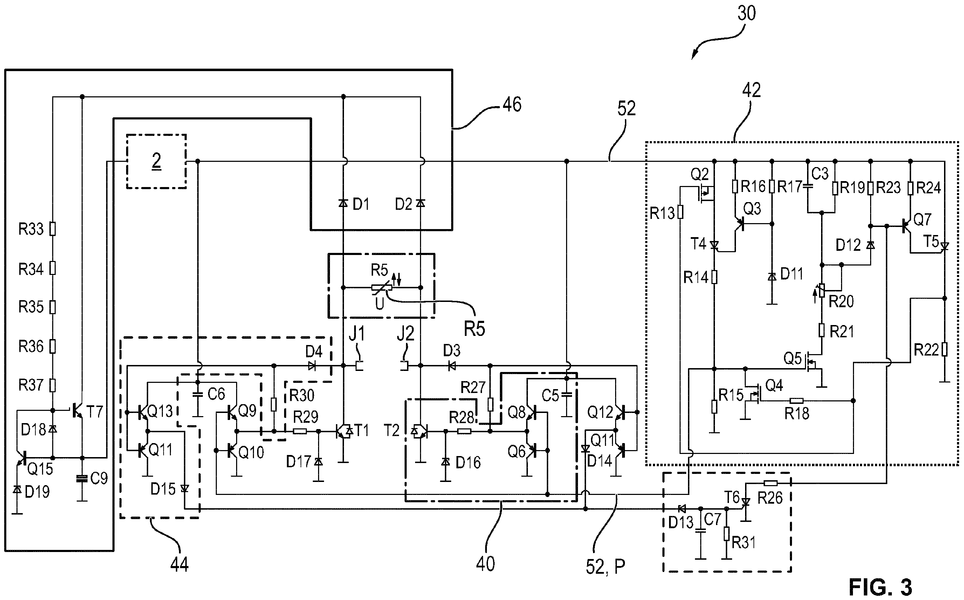

Die JP S5630590 offenbart eine Ladungspumpe wobei jede Spannungsstufe eine gegen ein Bezugspotential geschaltete Reihenschaltung einer Gleichrichterdiode und eines Ladekondensators sowie eines mittels einer Steuereinheit schaltbaren ersten Halbleiterschalters aufweist, wobei in jeder Spannungsstufe ein mittels der Steuereinheit schaltbare zweiter Halbleiterschalter parallel zu der Gleichrichterdiode und dem Ladekondensator geschaltet ist, und wobei die Gleichrichterdioden benachbarter Spannungsstufen in Reihe geschaltet sind (Siehe Abbildungen 1 und 3).

Aus der DE 196 38 616 A1 ist eine elektrische Uhr mit einer Leistungsversorgung zum Erzeugen elektrischer Energie unter Verwendung externer Energie beschrieben. Die Leistungsversorgung weist einen Verstärkerabschnitt mit wenigestens zwei Verstärkerschaltungen zum sequentiellen Wiederholen eines Aufladens durch die Leistungsversorgung zum Verstärken und zum Entladen einer Ladungsspannung, einen Speicherabschnitt zum Speichern einer durch den Verstärkerabschnitt entladenen Spannung und einen Taktausgabeabschnitt auf. In der US 2014/268936 A1 ist ein Verfahren zur Wandlung einer Niederspannung für Energiegewinnungsanwendungen bekannt. Hierbei ist eine Anlaufschaltung mit einer asynchronen Verstörkerschaltung zum Laden eines Ausgangs eines NMOS-Leistungstransistors, einem Ringoszillator und/oder einer Ladepumpe sowie eine Begleitschaltung vorgesehen.

Die EP 1 544 694 A1 offenbart eine elektrische Uhr mit einer Schwingeinheit, welche mit einer Niederspannung schwingen kann. Ein Schwingungssignal der Schwingeinheit wird über eine Wellenformeinheit verstärkt und einer Verstärkersteuereinheit zugeführt. Eine Verstärkereinheit wird veranlasst, ein Verstärkungsverhalten durch einen Verstärkungstakt mit der gleichen Frequenz wie eine Schwingungsfrequenz des Schwingungssignals unmittelbar nach dem Start der Schwingeinheit durchzuführen.

In der WO 2016/062427 A1 ist eine Trennvorrichtung zur Gleichstromunterbrechung zwischen einer Gleichstromquelle und einer elektrischen Einrichtung offenbart. Die Trennvorrichtung umfasst einen stromführenden mechanischen Schalter und eine mit diesem verschalteten Leistungselektronik sowie einen Energiespeicher. Die Aufladung des Energiespeichers erfolgt bei einem öffnendem Schalter mittels an diesem infolge eines Lichtbogens erzeugten Lichtbogenspannung. Ein Impulsgeber ist mit dem Energiespeicher verbunden, welcher mindestens einen Halbleiterschalter der Leistungselektronik derart ansteuert, dass diese den Schalter unter Verlöschen des Lichtbogens kurzschließt.

Der Erfindung liegt die Aufgabe zugrunde, ein besonders geeignetes Verfahren zur Wandlung einer Eingangsspannung in eine gegenüber dieser erhöhten Ausgangsspannung anzugeben. Der Erfindung liegt weiterhin die Aufgabe zugrunde einen nach einem derartigen Verfahren betreibbaren Spannungsvervielfacher sowie eine mit einem derartigen Spannungsvervielfacher ausgestatte Trennvorrichtung zu Gleichstromunterbrechung zwischen einer Gleichstromquelle, insbesondere einem Photovoltaikgenerator, und einer elektrischen Einrichtung, insbesondere einem Wechselrichter anzugeben. Insbesondere soll ein möglichst hohes Schaltvermögen und insbesondere eine möglichste hohe Ansteuergeschwindigkeit, das bedeutet sehr schnelle Ansteuerung der Leistungselektronik der Trennvorrichtung ermöglicht sein.

Hinsichtlich des Verfahrens wird die Aufgabe mit den Merkmalen des Anspruchs 1 und hinsichtlich des Spannungsvervielfachers mit den Merkmalen des Anspruchs 2 sowie hinsichtlich der Trennvorrichtung mit den Merkmalen des Anspruchs 6 erfindungsgemäß gelöst. Vorteilhafte Ausgestaltungen und Weiterbildungen sind Gegenstand der jeweiligen Unteransprüche.

Das erfindungsgemäße Verfahren ist zur Wandlung einer Eingangsspannung in eine gegenüber dieser erhöhten Ausgangsspannung geeignet und ausgestaltet. Hierzu ist zwischen einer Eingangsseite und einer Ausgangsseite verfahrensgemäß eine Anzahl von Spannungsstufen vorgesehen, welche jeweils eine gegen ein Bezugspotential geschaltete Reihenschaltung aufweisen. Die Reihenschaltungen umfassen jeweils eine Gleichrichterdiode und einen Ladekondensator sowie einen schaltbaren ersten Halbleiterschalter zwischen dem Ladekondensator und dem Bezugspotential. Parallel zu der Gleichrichterdiode und dem Ladekondensator ist jeweils ein zweiter schaltbarer Halbleiterschalter geschaltet, wobei die Gleichrichterdioden benachbarter Spannungsstufen zueinander in Reihe geschaltet sind.

In einem ersten Verfahrensschritt werden die ersten Halbleiterschalter geschlossen, das bedeutet elektrisch leitend geschaltet, und die zweiten Halbleiterschalter geöffnet, das bedeutet elektrisch nicht leitend oder sperrend geschaltet. Somit fließt aufgrund der Eingangsspannung ein Strom über die Gleichrichterdioden zu dem Bezugspotential, so dass die Ladekondensatoren der Spannungsstufen mittels der Eingangsspannung aufgeladen werden. Dadurch wird eine jeweilige Einzelspannung an den Ladekondensatoren erzeugt. Die Ladekondensatoren der Spannungsstufen sind hierbei effektiv zueinander parallel geschaltet.

In einem darauffolgenden zweiten Verfahrensschritt werden anschließend die ersten Halbleiterschalter geöffnet und die zweiten Halbleiterschalter geschlossen. Dadurch werden die Ladekondensatoren entlang der Gleichrichterdioden zueinander in Reihe geschaltet, so dass sich die an den Ladekondensatoren erzeugten Einzelspannungen sowie die Eingangsspannung an der Ausgangsseite der Spannungsstufen zur Ausgangsspannung addieren. Dadurch ist ein besonders geeignetes Verfahren zur Wandlung einer Eingangsspannung in eine gegenüber dieser erhöhten Ausgangsspannung realisiert.

Durch eine geeignete Dimensionierung der Anzahl von Spannungsstufen sowie deren Ladekondensatoren ist es durch das erfindungsgemäße Verfahren möglich, eine nahezu beliebig niedrige Eingangsspannung in eine Ausgangsspannung nahezu beliebiger Höhe zu wandeln. Durch das Verfahren ist es somit ermöglicht, MOS- oder IGBT-Halbleiterschalter auch bei niedrigen Eingangsspannungen sicher und zuverlässig mittels der erzeugbaren Ausgangsspannung anzusteuern. Insbesondere ist es somit möglich Schaltverzugszeiten zu reduzieren.

In einer bevorzugten Anwendung wird das erfindungsgemäße Verfahren mittels eines Spannungsvervielfachers durchgeführt. Der Spannungsvervielfacher ist hierbei insbesondere für eine Trennvorrichtung zur Gleichstromunterbrechung geeignet und eingerichtet. Der Spannungsvervielfacher umfasst eine Steuereinheit zur Durchführung des vorstehend beschriebenen Verfahrens. Die Steuereinheit steuert hierbei mindestens eine, vorzugsweise mindestens zwei, jeweils eine Einzelspannung bereitstellende Spannungsstufen an.

Jede Spannungsstufe weist eine gegen ein Bezugspotential geschaltete Reihenschaltung einer Gleichrichterdiode und eines Ladekondensators sowie eines mittels der Steuereinheit schaltbaren ersten Halbleiterschalters auf. Des Weiteren ist in jeder Spannungsstufe ein mittels der Steuereinheit schaltbarer zweiter Halbleiterschalter parallel zu der Gleichrichterdiode und dem Ladekondensators geschaltet. Die Gleichrichterdioden benachbarter Spannungsstufen sind hierbei in Reihe geschaltet.

Mit dem erfindungsgemäßen Spannungsvervielfacher ist es somit möglich eine vergleichsweise niedrige Eingangsspannung in kurzer Zeit auf eine vergleichsweise hohe Ausgangsspannung zu wandeln. Insbesondere bei einem Einsatz in einer Trennvorrichtung wird durch die innerhalb einer kurzen Zeitdauer bereitgestellte Ausgangsspannung ein hohes Schaltvermögen und somit eine hohe Ansteuergeschwindigkeit, das bedeutet eine sehr schnelle Ansteuerung einer Leistungselektronik der Trennvorrichtung, ermöglicht.

Die Steuereinheit umfasst beispielsweise einen Controller, das bedeutet ein Steuergerät. Der Controller ist hierbei allgemein - programm- und/oder schaltungstechnisch - zur Durchführung des vorstehend beschriebenen Verfahrens geeignet und eingerichtet. Der Controller ist somit konkret dazu eingerichtet zunächst die ersten Halbleiterschalter zu schließen und die zweiten Halbleiterschalter zu öffnen, so dass die Ladekondensatoren der Spannungsstufen mittels der Eingangsspannung aufgeladen werden, und anschließend die ersten Halbleiterschalter zu öffnen und die zweiten Halbleiterschalter zu schließen, so dass sich die an den Ladekondensatoren erzeugten Einzelspannungen entlang der in Reihe geschalteten Gleichrichterdioden zu der Ausgangsspannung addieren.

In einer möglichen Ausgestaltung ist der Controller zumindest im Kern durch einen Mikrocontroller mit einem Prozessor und einem Datenspeicher gebildet, in dem die Funktionalität zur Durchführung des Verfahrens in Form einer Betriebssoftware (Firmware) programmtechnisch implementiert ist, so dass das Verfahren - gegebenenfalls in Interaktion mit einem Benutzer - bei Ausführung der Betriebssoftware in dem Mikrocontroller automatisch durchgeführt wird.

Der Controller kann im Rahmen der Erfindung alternativ auch durch ein nichtprogrammierbares elektronisches Bauteil, zum Beispiel einen ASIC (anwendungsspezifischer integrierter Schaltkreis), gebildet sein, in dem die Funktionalität zur Durchführung des Verfahrens mit schaltungstechnischen Mitteln implementiert ist.

Vorzugsweise ist die Steuereinheit mittels rein schaltungstechnischen Mitteln, das bedeutet controller- beziehungsweise steuergerätlos, ausgeführt, wobei das Verfahren selbsttätig oder automatisch bei einer anliegenden Eingangsspannung ausgeführt wird. Dies überträgt sich in der Folge vorteilhaft auf die Herstellungskosten des Spannungsvervielfachers. Des Weiteren wird die Zuverlässigkeit und Schaltverzugszeit des Spannungsvervielfachers verbessert, was insbesondere vorteilhaft hinsichtlich einer Anwendung bei einer Trennvorrichtung zur Gleichstromunterbrechung ist.

In einer geeigneten Weiterbildung ist den Spannungsstufen eingangsseitig, das bedeutet an einem mit der Eingangsspannung gekoppelten Klemmenpunkt, ein Kondensator der Steuereinheit vorgeschaltet. Der Kondensator steuert hierbei im geladenen Zustand die ersten Halbleiterschalter der Spannungsstufen schließend an. Dadurch ist eine zuverlässige Ansteuerung der ersten Halbleiterschalter gewährleistet.

Dem Ladekondensator und dem zweiten Halbleiterschalter ist ausgangsseitig, das bedeutet an einem Klemmenpunkt an welchem die Ausgangsspannung abgreifbar ist, eine Zenerdiode der Steuereinheit parallel geschaltet. Wird der Ladekondensator der ausgangsseitigen Spannungsstufe zur Erzeugung der Einzelspannung aufgeladen, schaltet die Zenerdiode durch, wobei ein dritter Halbleiterschalter der Steuereinheit derart angesteuert wird, dass die ersten Halbleiterschalter der Spannungsstufen öffnen. Dadurch werden die ersten Halbleiterschalter am Ende des ersten Verfahrensschritts zuverlässig geöffnet.

In einer zweckmäßigen Ausgestaltung ist zur Ansteuerung des zweiten Halbleiterschalters der jeweiligen Spannungsstufe ein der Reihenschaltung parallel geschalteter Spannungsteiler vorgesehen. Der Abgreifpunkt des Spannungsteilers ist hierbei an einen Steuereingang des zweiten Halbleiterschalters geführt. Nach einem Öffnen der ersten Halbleiterschalter fließt aufgrund der Eingangsspannung ein Strom über den Spannungsteiler, sodass die am Abgreifpunkt erzeugte Spannung zur zuverlässigen Ansteuerung der zweiten Halbleiterschalter genutzt wird. Dadurch ist ein zuverlässiges Schließen der zweiten Halbleiterschalter zu Beginn des zweiten Verfahrensschritts gewährleistet.

In einer bevorzugten Ausführung ist der oder jeder erste Halbleiterschalter als ein MOS-FET (metal-oxide-semiconductor field-effect transistor) ausgeführt, welcher drainseitig an den Ladekondensator und sourceseitig an das Bezugspotential geführt ist. Der oder jeder zweite Halbleiterschalter ist hierbei als ein Bipolartransistor ausgeführt, welcher entlang der Kollektor-Emitter-Strecke der Gleichrichterdiode und dem Ladekondensator parallel geschaltet ist und basisseitig an einen Gateanschluss des ersten Halbleiterschalters geführt ist. Dadurch ist eine besonders zweckmäßige Ausführung der ersten und zweiten Halbleiterschalter hinsichtlich der schaltungstechnischen Ansteuerung mittels der Steuereinheit realisiert.

Die nachfolgend auch als Hybridschalter bezeichnete erfindungsgemäße Trennvorrichtung ist zur Gleichstromunterbrechung zwischen einer Gleichstromquelle und einer elektrischen Einrichtung angeordnet. Der Hybridschalter weist einen stromführenden mechanischen Schalter und eine mit diesem verschaltete Leistungselektronik sowie ein Netzteil auf, dessen Aufladung mittels einer bei öffnendem Schalter an diesem infolge eines Lichtbogens erzeugten Lichtbogenspannung erfolgt.

Der Hybridschalter umfasst des Weiteren einen nachfolgend auch als Impulsgeberschaltung bezeichneten Impulsgeber, der mit dem Netzteil verbunden ist. Der Impulsgeber steuert mindestens einen Halbleiterschalter der Leistungselektronik derart an, dass diese den mechanischen Schalter unter Verlöschen des Lichtbogens kurzschließt, was zu einem Verlöschen des Lichtbogens führt. Zur Verringerung der Schaltverzugszeit des Halbleiterschalters der Leistungselektronik, ist zwischen dem Netzteil und dem Impulsgeber ein erfindungsgemäßer Spannungsvervielfacher verschaltet. Der Spannungsvervielfacher wandelt die durch das Netzteil erzeugte Eingangsspannung in eine zur Ansteuerung des Impulsgebers beziehungsweise der Impulsgeberschaltung geeignete Ausgangsspannung.

In vorteilhafter Ausgestaltung ist der Spannungsvervielfacher eingangsseitig mit einem Energiespeicher des Netzteils verbunden. Der Energiespeicher wird mittels der durch den Lichtbogen erzeugten Lichtbogenspannung aufgeladen, wobei diese Energie als Eingangsspannung dem Spannungsvervielfacher zugeführt wird.

In zweckmäßiger Weiterbildung weist der Impulsgeber (die Impulsgeberschaltung) einen mit dem Ausgang des Spannungsvervielfachers verbundenen Halbleiterschalter auf, der leitend gesteuert ist, wenn die Ausgangsspannung des Spannungsvervielfachers einen eingestellten oder einstellbaren Spannungswert erreicht, der nachfolgend auch als Betriebsspannung bezeichnet wird. Dieser Halbleiterschalter des Impulsgebers ist geeigneterweise als ein Thyristor ausgeführt.

In einer geeigneten Weiterbildung greift die Leistungselektronik an einem diesem Halbleiterschalter des Impulsgebers nachgeordneten Spannungsabgriff ansteuerseitig einen, vorzugsweise aus der Betriebsspannung generierten, Steuerimpuls ab. Mit anderen Worten ist der Impulsgeber über diesen Spannungsabgriff mit der Steuerseite der Leistungselektronik, das bedeutet mit dem mindestens einen Halbleiterschalter steuerseitig verbunden, so dass dieser bei Vorliegen des Steuerimpulses oder Steuersignals des Impulsgebers durchsteuert, also leitend geschaltet wird, und das Kurzschließen des mechanischen Schalters, insbesondere dessen Schalterkontakte oder entsprechender Kontaktanschlüsse, bewirkt. Vorzugsweise erzeugt der Impulsgeber pro Schaltvorgang lediglich einen Steuerimpuls, das bedeutet einen Einzelimpuls. Aufgrund des Spannungsvervielfachers wird die Zeitdauer zur Erzeugung des Einzelimpulses wesentlich verringert, sodass der Verschleiß an den Schalterkontakten infolge des Lichtbogens reduziert wird.

Die Erfindung geht dabei von der Überlegung aus, dass mittels des durch den Spannungsvervielfacher gesteuerten Impulsgebers, der vorzugsweise pro Schalvorgang nur einen Einzelimpuls erzeugt, eine sehr schnelle Ansteuerung der Leistungselektronik einer hybriden Trennvorrichtung erreicht und somit deren Schaltvermögen besonders hoch, das heißt gegenüber bekannten Trennvorrichtungen erhöht ist.

Die erfindungsgemäße Trennvorrichtung ist vorzugsweise zur Gleichstromunterbrechung im Gleichspannungsbereich geeigneterweise auch bis zu 1500V (DC) vorgesehen. Beim bevorzugten Einsatz des zusätzlichen mechanischen Trennschalters ist diese autarke, hybride Trennvorrichtung daher zur zuverlässigen und berührungssicheren galvanischen Gleichstromunterbrechung sowohl zwischen einer Photovoltaikanlage und einem dieser zugeordneten Wechselrichter als auch in Verbindung mit beispielsweise einer Brennstoffzellenanlage oder einem Akkumulator (Batterie) besonders geeignet.

Nachfolgend werden Ausführungsbeispiele der Erfindung anhand einer Zeichnung näher erläutert. Darin zeigen:
- Fig. 1: in einem schematischen Schaltbild einen Spannungsvervielfacher mit einer Anzahl von Spannungsstufen,
- Fig. 2: in einem Blockschaltbild eine zwischen einem Photovoltaikgenerator und einem Wechselrichter angeordnete hybride Trennvorrichtung mit einem mechanischen Schalter und einer Leistungselektronik inklusive einer Schutzschaltung sowie mit einem Impulsgeber, einem Spannungsvervielfacher und einem Netzteil,
- Fig. 3: in einem detaillierten Schaltbild die Trennvorrichtung mit zwei Halbleiterschaltern der Leistungselektronik und deren Treiber- und Schutzschaltungen sowie mit dem Impulsgeber und mit dem Spannungsvervielfacher sowie mit dem Netzteil mit einem Kondensatoren als Energiespeicher,
- Fig. 4: den Impulsgeber als Teilschaltung der hybriden Trennvorrichtung,
- Fig. 5: die Leistungselektronik mit Treiberendstufe eines der Halbeiterschalter sowie zwei Kontaktanschlüsse des mechanischen Schalters als Teilschaltung der hybriden Trennvorrichtung,
- Fig. 6: die Schutzschaltung mit einer Messschaltung zur Überstromerkennung als Teilschaltung der hybriden Trennvorrichtung,
- Fig. 7: das Netzteil mit einer Gleichrichterschaltung als Teilschaltung der hybriden Trennvorrichtung, und
- Fig. 8: den Spannungsvervielfacher als Teilschaltung der hybriden Trennvorrichtung.

Einander entsprechende Teile und Größen sind in allen Figuren stets mit den gleichen Bezugszeichen versehen.

Die Fig. 1 zeigt schematisch einen Spannungsvervielfacher 2 zur Wandlung einer Eingangsspannung U_{E} in eine gegenüber dieser erhöhten Ausgangsspannung U_{A}. Die Eingangsspannung U_{E} liegt hierbei eingangsseitig zwischen einem ersten Klemmenanschluss beziehungsweise Pluspol 4 und einem zweiten Klemmenanschluss beziehungsweise Minuspol 6, wobei die Ausgangsspannung U_{A} an einem Abgriffpunkt 8 abgreifbar ist.

Der Spannungsvervielfacher 2 weist eine Steuereinheit 10, beispielsweise in Form eines Controllers, auf. Die Steuereinheit 10 ist signaltechnisch mit einer Anzahl von zwischen den Klemmenanschlüssen 4, 6 und dem Abgriffpunkt 8 parallel geschalteten Spannungsstufen 12 gekoppelt. In der Fig. 1 sind beispielshaft drei derartige Spannungsstufen 12 dargestellt.

Zwischen dem Pluspol 4 und dem Abgriffpunkt 8 erstreckt sich eine Leitung 14, entlang welcher die Spannungsstufen 12 parallel zueinander geschaltet sind. Jede Spannungsstufe 12 weist hierbei eine Reihenschaltung 16 einer in die Leitung 14 geschalteten Gleichrichterdiode 18 und eines Ladekondensators 20 sowie eines schaltbaren ersten Halbleiterschalters 22 auf. Mit anderen Worten sind die Gleichrichterdioden 18 benachbarter Spannungsstufen 12 zueinander entlang der Leitung 14 in Reihe geschaltet. Die Reihenschaltung 16 ist hierbei gegen ein Bezugspotential U_{G} geführt, welches in dem Ausführungsbeispiel der Fig. 1 insbesondere ein Massenpotential ist. Parallel zu der Gleichrichterdiode 18 und dem Ladekondensator 20 ist jeweils ein schaltbarer zweiter Halbleiterschalter 24 in die jeweilige Spannungsstufe 12 geschaltet. Beispielhaft sind in der Fig. 1 lediglich die Schaltteile für eine Spannungsstufe 12 mit Bezugszeichen versehen.

Die Halbleiterschalter 22 der Spannungsstufen 12 sind mittels einer ersten Signalleitung 26 signaltechnisch von der Steuereinheit 10 ansteuerbar. Mittels einer zweiten Signalleitung 28 sind die Halbleiterschaler 24 entsprechend signaltechnisch an die Steuereinheit 10 geführt.

Im Betrieb wird der Spannungsvervielfacher 2 über die Klemmenanschlüsse 4 und 6 mit der Eingangsspannung U_{E} versorgt. Die Steuereinheit 10 steuert hierbei die Halbleiterschalter 22 und 24 der Spannungsstufen 12 gemäß dem nachfolgend erläuterten erfindungsgemäßen Verfahren an.

Zu Beginn werden die Halbleiterschalter 22 von der Steuereinheit 10 mittels der Signalleitung 26 geschlossen, während die Halbleiterschalter 24 mittels der Signalleitung 24 öffnend von der Steuereinheit 10 angesteuert werden. Mit anderen Worten werden die Halbleiterschalter 22 leitend und die Halbleiterschalter 24 sperrend geschaltet. Dadurch sind die Ladekondensatoren 20 der Spannungsstufen 12 entlang der Leitung 14 jeweils zwischen dem Pluspol 4 und dem Bezugspotential U_{G} geschaltet. Dadurch sind die Ladekondensatoren 20 der Spannungsstufen 12 sind zueinander parallel geschaltet, sodass sie über die Gleichrichterdioden 18 auf eine jeweilige Einzelspannung U_{Z} aufgeladen werden.

Die Steuereinheit 10 überwacht im Betrieb die am ausgangsseitigen Ladekondensator 20, das bedeutet an dem Ladekondensator 20 der dem Abgriffpunkt 8 nächstgelegenen Spannungsstufe 12, erzeugte Einzelspannung U_{Z} (Ladespannung). Erreicht oder Überschreitet diese Einzelspannung Uz einen vorgegebenen oder hinterlegten Spannungsschwellwert, so werden von der Steuereinheit 10 die Halbleiterschalter 22 geöffnet und die Halbleiterschalter 24 geschlossen. Dadurch werden die vorher parallel geschalteten Ladekondensatoren 20 entlang der Leitung 14 zueinander in Reihe geschaltet. Somit ergibt sich an dem Abgriffpunkt 8 eine Summenspannung der Einzelspannungen U_{Z} der Ladekondensatoren 20 als Ausgangsspannung U_{A}. Je nach Anzahl der Spannungsstufen 12 ist es möglich, eine Ausgangsspannung U_{A} zu erzeugen, welche ein nahezu beliebiges Vielfaches der Eingangsspannung U_{E} ist.

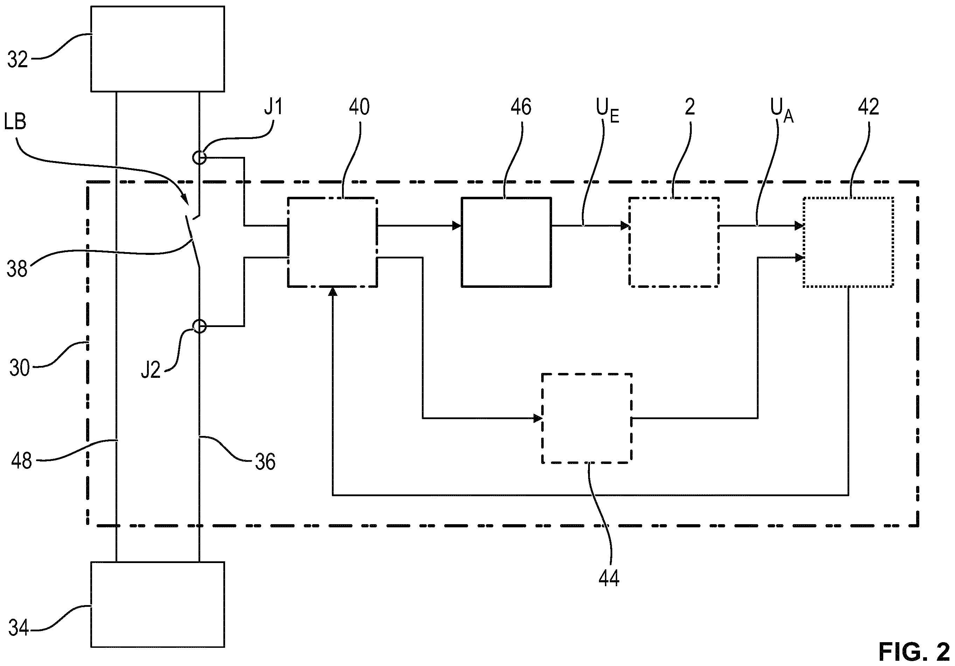

Anhand der Figuren 2 bis 8 ist nachfolgend ein Anwendungsbeispiel eines oder des Spannungsvervielfachers 2 in einer Trennvorrichtung 30 näher erläutert.

Fig. 2 zeigt schematisch eine Trennvorrichtung 30, die im Ausführungsbeispiel zwischen einen Photovoltaikgenerator als Gleichstromquelle 32 und einen Wechselrichter als elektrische Einrichtung 34 geschaltet ist. Der Photovoltaikgenerator 32 kann in nicht näher dargestellter Art und Weise eine Anzahl von Solarmodulen umfassen, die zueinander parallel liegend an einen gemeinsamen Generatoranschlusskasten geführt sind, der quasi als Energiesammelpunkt dient.

Die Trennvorrichtung 30 umfasst in einem den Pluspol repräsentierenden Hauptstrompfad 36 einen nachfolgend auch als mechanischen Schalter bezeichneten Schaltkontakt 38 und eine hierzu parallel geschaltete Leistungselektronik 40 sowie einen diese ansteuernden Impulsgeber 42. Die Trennvorrichtung 30 umfasst des Weiteren eine Schutzschaltung 44 und ein Netzteil 46. Der Spannungsvervielfacher 2 ist zwischen dem Netzteil 46 und dem Impulsgeber 42 geschaltet.

Der mechanische Schalter 38 und die Leistungselektronik 40 sowie der diese ansteuernde Impulsgeber 42 bilden einen autarken hybriden Trennschalter (Hybridschalter). In einer den Minuspol repräsentierenden Rückführleitung 48 der Trennvorrichtung 30 - und damit der Gesamtanlage - kann in nicht näher dargestellter Art und Weise eine weiterer hybriden Trennschalter geschaltet sein. Sowohl in die den Pluspol repräsentierende Hinführungsleitung (Hauptpfad) 36 als auch in die Rückführungsleitung 48 können in nicht näher dargestellter Art und Weise miteinander mechanisch gekoppelte Schaltkontakte eines weiteren mechanischen Trennelementes für eine vollständige galvanische Trennung bzw. Gleichstromunterbrechung zwischen dem Photovoltaikgenerator 32 und dem Wechselrichter 34 angeordnet sein.

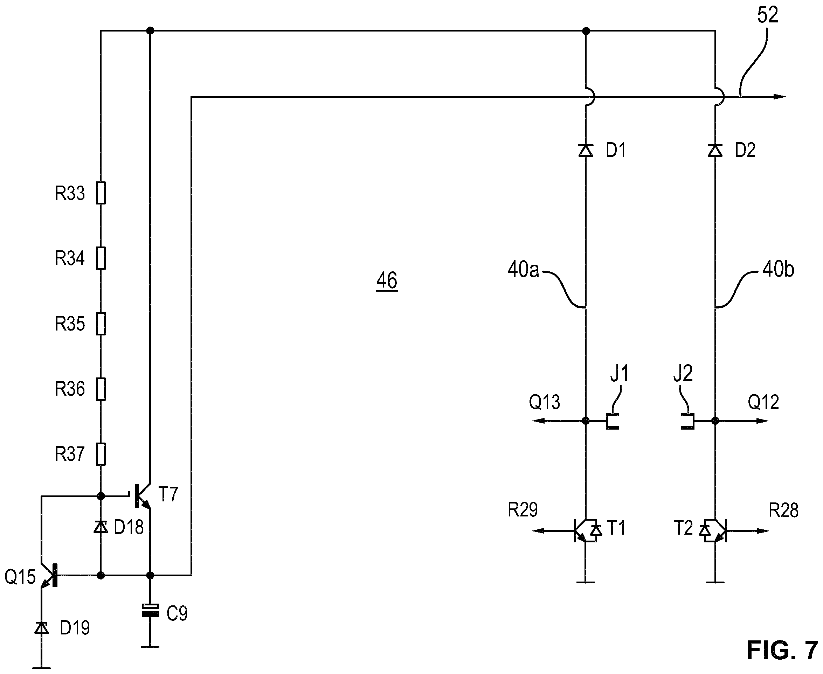

Wird während des Betriebs der dann stromdurchflossene mechanische Schalter 38 geöffnet, so bildet sich zwischen dessen Schaltkontakten ein Lichtbogen LB. Mittels der dadurch bedingten Lichtbogenspannung über den in Figur 3 gezeigten Schalteranschlüssen J1 und J2 wird ein Kondensator C9 (Figuren 3 und 7) als Energiespeicher geladen. Die Ladespannung des Kondensators C9 wird als Eingangsspannung U_{E} an einen Klemmenanschluss 50 des Spannungsvervielfachers 2 geführt. Der Spannungsvervielfacher 2 erzeugt mittels dieser Eingangsspannung U_{E} eine gegenüber dieser erhöhten Ausgangsspannung U_{A}. Sobald die Ausgangsspannung U_{A} einen bestimmten Spannungswert erreicht, steuert der Impulsgeber 42 die Leistungselektronik 40 an, woraufhin diese den Schalter 38 kurzschließt und der Lichtbogen LB verlischt.

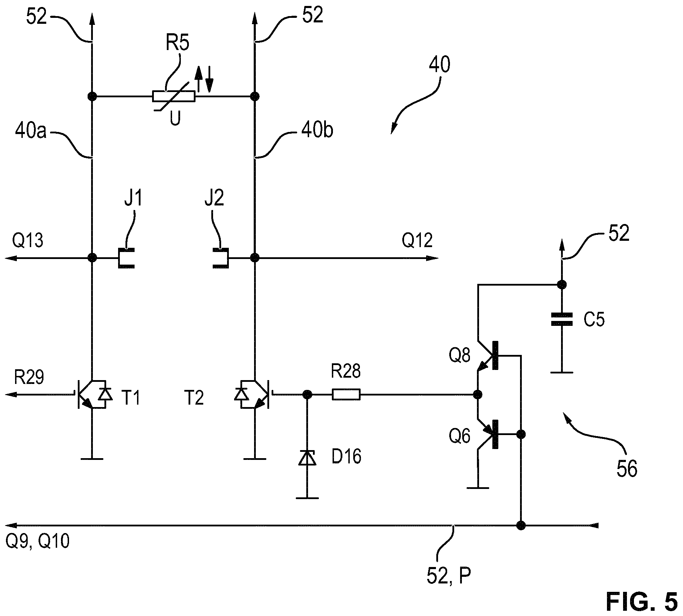

Hierbei bleibt die Leistungselektronik 40 geeigneterweise für eine gewisse Zeit, das bedeutet für ein eingestelltes oder einstellbares Zeitglied eingeschaltet, um ein Entionisieren der Schaltstrecke zu ermöglichen. Nach Ablauf der Zeitspanne beziehungsweise des entsprechenden Zeitgliedes schaltet der Impulsgeber 42 die Leistungselektronik 40 aus. Eine beim Schaltvorgang entstehende Überspannung wird mit mindestens einem Varistor R5 (Figuren 3 und 5) begrenzt. Die Schutzschaltung 44 überwacht hierbei während des Schaltvorgangs einen jeweiligen Leistungshalbleiter (IGBT) T1, T2 der Leistungselektronik 40, um dessen Zerstörung durch einen unzulässig hohen Strom zu vermeiden.

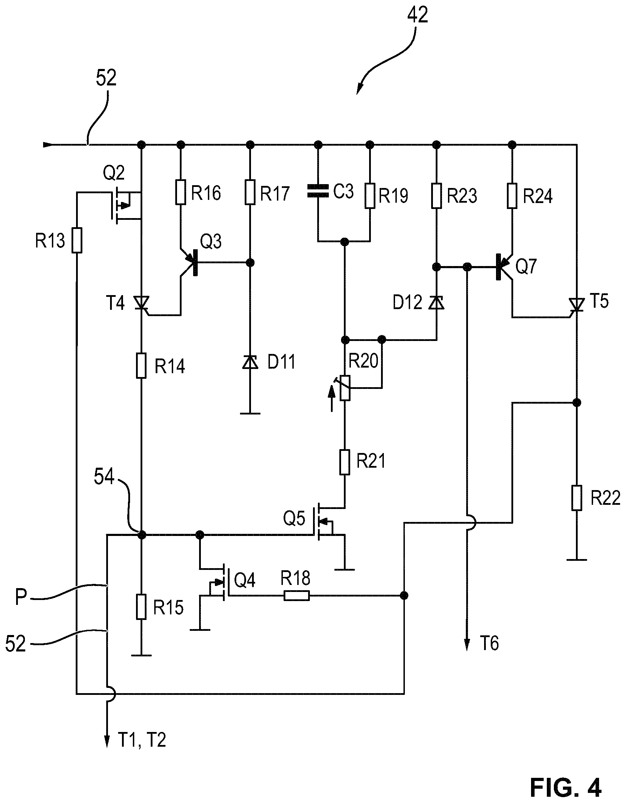

Figur 3 zeigt die Trennvorrichtung 30 im detaillierten Schaltbild, wobei dort die in Figur 2 verwendeten unterschiedlichen Linienarten die Bauteile der Leistungselektronik 40, des Impulsgebers 42, des Spannungsvervielfachers 2, der Schutzschaltung 44 und des Netzteils 46 umrahmen. Da die Leistungselektronik 40 vorzugsweise zwei Halbleiterschalter in Form der gezeigten IGBT's T1 und T2 aufweist, sind auch jeweils zwei Schutzschaltungen 44 und zwei Treiberschaltungen für die IGBT's T1 und T2 vorgesehen. Dabei ist aus Gründen der besseren Übersichtlichkeit jeweils lediglich eine dieser Schaltungen mit deren Bauelementen mit der entsprechenden Linienart umrandet. Die einzelnen Teilschaltungen sind in den Figuren 4 bis 7 separat dargestellt.

Gemäß den Figuren 3 und 4 umfasst der Impulsgeber 7 einen über eine Verbindung 52 an den Kondensator C9 geführten Halbleiterschalter in Form eines Thyristors T4, wobei dieser anodenseitig über einen PMOS-Transistor (P-Kanal-Metall-Oxyd-Halbleiter-Transistor) Q2, das heißt über dessen Kollektor-Emitter-Strecke an die zum Kondensator C9 führende Verbindung 52 angeschlossen ist. Der Thyristor T4 ist ansteuerseitig über einen mit Widerständen R16 und R17 sowie mit einer Zenerdiode D11 beschalteten PMOS-Transistor Q3 verbunden. Kathodenseitig ist der Thyristor T4 über einen Widerstand R14 an einen Spannungsabgriff 54 geführt, welcher über einen Widerstand R15 mit Masse verbunden ist. Des Weiteren ist der Spannungsabgriff 54 über die Drain-Source-Strecke eines weiteren Transistors Q4, vorliegend eines MOS- oder NMOS-Transistors, gegen Masse (Bezugspotential) geschaltet. Am Spannungsabgriff 54 liegt zudem die Basis oder das Gate eines weiteren Transistors (MOS- oder NMOS-Transistor) Q5, dessen Drain-Source-Strecke über Widerstände R19, R20 als Stellwiderstand und R21 sowie einen dem Widerstand R19 parallel geschalteten Kondensator C3 zwischen die zum Kondensator C9 führende Verbindung 52 und Masse geschaltet ist.

Parallel zum RC-Glied R19 und C3 liegt eine Reihenschaltung aus einem Widerstand R23 und einer Zenerdiode D12, an die kathodenseitig die Basis eines PNP-Transistors Q7 geführt ist. Die Steuerseite eines weiteren Thyristors T5 ist über den Transistor Q7 und einen Widerstand R24 an die zum Kondensator C9 führende Verbindung 52 geschaltet. Die Anoden-Kathoden-Strecke des Thyristors T5 ist zwischen die zum Kondensator C9 führende Verbindung 52 und - über einen Widerstand R22 - an Masse geführt. Ein kathodenseitiger Abgriff dieses Thyristors T5 ist über einen Widerstand R18 an das Gate (Basis) des Transistors Q4 sowie über einen Widerstand R13 an das Gate (Basis) des Transistors Q2 geführt. Die gezeigte und beschriebene Schaltung stellt zusätzlich zum Halbleiterschalter T4 eine entsprechend beschaltete Halbleiterschaltung des Impulsgenerators oder Impulsgebers 42 dar. Der Impulsgeber 42 generiert den oder jeden Steuerimpuls P für die beiden IGBT's T1, T2 der Leistungselektronik 6, wie nachfolgend erläutert.

Die beiden Thyristoren T4 und T5 des Impulsgebers 42 befinden sich zu Beginn im sperrenden Zustand, so dass sich das Gate des Transistors Q2 auf Massepotential befindet. Steigt infolge eines beim Öffnen des mechanischen Schalters 5 entstehenden Lichtbogens LB die durch die Ausgangsspannung des Spannungsvervielfachers 2 bewirkte Ladespannung des Kondensators C5 und damit die Betriebsspannung an, so steigt auch die negative Gate-Source-Spannung des Transistors Q2, so dass dieser durchschaltet und die Anode des Thyristors T4 das Potential der Betriebsspannung hat. Steigt diese Spannung weiter an, so beginnt die Zenerdiode D11 in den leitenden Zustand überzugehen. Der dadurch bedingte Stromfluss verursacht einen Spannungsfall am Widerstand R17. Überschreitet dieser Spannungsfall den Schwellwert der Basis-Emitter-Spannung des Transistors Q3, so wird dieser leitfähig. Um den Transistor Q3 vor einer Zerstörung zu schützen, wird der Strom durch den Widerstand R16 begrenzt. Dieser Strom führt zu einer Zündung des Thyristors T4. Der Wert des Widerstands R14 ist wesentlich kleiner als derjenige des Widerstandes R15, so dass das Potential zwischen diesen beiden Widerständen R14, R15 am Spannungsabgriff 54, an welchem der Steuerimpuls P für die Leistungselektronik 6 abgegriffen wird, nur geringfügig unterhalb der Betriebsspannung ist.

Sobald der Thyristor T4 gezündet hat, schaltet der Transistor Q5 durch und der Kondensator C3 wird über die Widerstände R20 und R21 geladen. Da der Kondensator C3 zu Beginn ungeladen ist, befindet sich das Potential der Anode der Zenerdiode D12 auf Betriebsspannung. Durch das Aufladen des Kondensators C3 verschiebt sich das Potential nach Masse. Ist dieses Potential derart abgesunken, dass die Zenerdiode D12 leitend wird, so fließt ein Strom durch den Widerstand R23. Übersteigt der Spannungsfall über diesem Widerstand R23 den Schwellwert der Basis-Emitter-Spannung des PNP-Transistors Q7, so schaltet dieser durch. Der Widerstand R24 bewirkt hierbei eine Strombegrenzung und schützt den Transistor Q7.

Der über den Transistor Q7 fließende Strom führt zur Zündung des Thyristors T5, so dass das Potential an dessen Kathode auf die Betriebsspannung - abzüglich der Durchlassspannung - ansteigt. Somit schaltet auch der Transistor Q4 durch und zieht das Potential zwischen den Widerständen R14 und R15 am Spannungsabgriff S1 auf Masse. Zudem sperrt nun der Transistor Q2 und bewirkt ein Löschen des Thyristors T4. Somit sperrt auch der Transistor Q5 und der Kondensator C3 wird über den Widerstand R19 entladen. Der Thyristor T5 bleibt solange leitfähig, bis der Kondensator C9 entladen ist. Da der Kondensator C9 während einer Lichtbodenphase und auch während der Schaltüberspannung nachgeladen wird, wird nur ein einziger Steuerimpuls ausgelöst.

Der in den Figuren 3 und 5 gezeigten Leistungselektronik 40 ist eine Treiberstufe 56 zugeordnet. Die IGBT's T1 und T2 der Leistungselektronik 40 bilden den unteren Teil einer B2-Gleichrichterbrücke. Durch Verwendung von zwei Leistungshalbleitern mit Freilaufdiode in Form der IGBT's T1 und T2 wird eine bidirektional einsetzbare Schaltung erreicht. Sollte der veranschaulichte Schalter- oder Kontaktanschluss J2 des mechanischen Schalters 38 positives und der andere Schalteranschluss J1 negatives Potential aufweisen, so kann der Strom durch den IGBT T2 und die Freilaufdiode des IGBT's T1 fließen. Bei umgekehrter Polarität ist ein Stromfluss durch den IGBT T1 und die Freilaufdiode des IGBT's T2 möglich. Da das Steuersignal eines IGBT's auf dessen Inversbetrieb keinen Einfluss hat, werden stets beide IGBT's T1 und T2 der Leistungselektronik 40 angesteuert.

Da die Treiberschaltungen 56 beider IGBT's T1 und T2 identisch aufgebaut sind, wird nachfolgend nur eine der beiden Treiberschaltungen 56 beschrieben. Die Treiberschaltung 56 umfasst einen NPN-Transistor Q8 und einen PNP-Transistor Q6, die zu einer komplementären Endstufe verschaltet sind. Gibt der Impulsgeber 42 den Steuerimpuls P an die Basen der beiden Transistoren Q6 und Q8 ab, so wirken diese als Stromverstärker und ermöglichen ein schnelles Umladen des Gates des jeweiligen IGBT's T2, T1. Hierdurch wird ein besonders schneller Schaltvorgang erzielt. Ein Kondensator C5 der Treiberschaltung 56 stellt den Umladestrom bereit. Der IGBT T2 ist durch einen Widerstand R28 bedämpft, da es aufgrund parasitärer Induktivitäten und Kapazitäten zu Schwingungsvorgängen während der Ansteuerung des jeweiligen IGBT's T2 kommen kann. Eine Zenerdiode D16 der Treiberschaltung 11 schützt das Gate des IGBT's T2 vor Überspannungen, sollten dennoch Schwingungen auftreten. Da es beim Schalten von induktiven Lasten aufgrund der steilen Schaltflanke des IGBT's T2 zu Überspannungen kommen kann, begrenzt der Varistor R5 die Überspannung, um eine Zerstörung der Leistungshalbleiter T1, T2 zu verhindern.

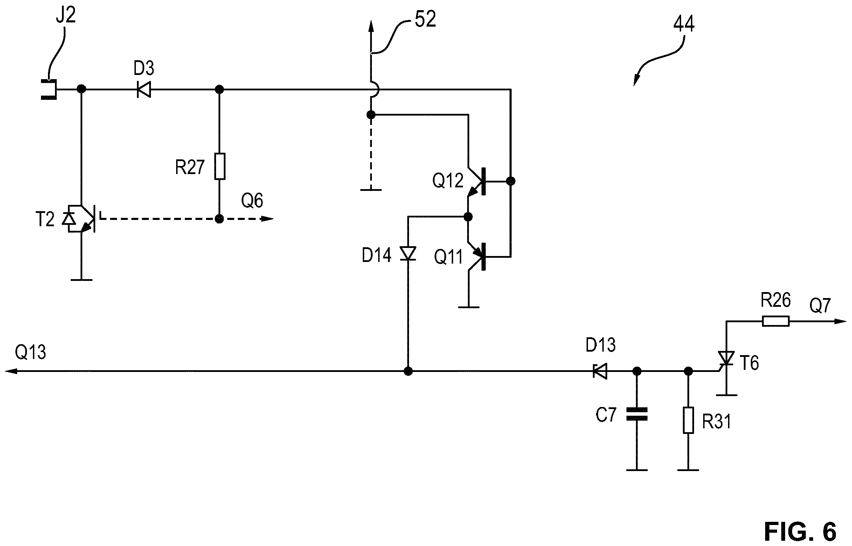

Die Figuren 3 und 6 zeigen die Mess- und Schutzschaltung 44 der Trennvorrichtung 30. Obwohl IGBT's als Halbleiterschalter der Leistungselektronik 40 prinzipiell kurzschlussfest sind, müssen diese dennoch im Fehlerfall innerhalb von 10 µs ausgeschaltet werden. Die Schaltungen 44 zur Überwachung beziehungsweise Messung des Stroms der beiden IGBT's T1, T2 sind identisch aufgebaut, so dass Figur 6 wiederum lediglich eine solche Schaltung 44 zeigt. Die Messschaltung umfasst im Wesentlichen eine Reihenschaltung aus einem Widerstand R27 und einer Diode D3, die zwischen das Gate und den Kollektor des IGBT's T2 geschaltet ist/sind. Das Steuersignal des IGBT's T2 wird über den Widerstand R27 und die Diode D3 auf seine Kollektor-Emitter-Strecke gegeben.

Das Potential zwischen der Diode D3 und dem Widerstand R27 entspricht der Durchlassspannung des IGBT's T2, zuzüglich der Sättigungsspannung der Diode D3. Somit kann in Kenntnis der IGBT-Kennlinie eine Aussage über den Stromfluss durch diesen Leistungshalbleiter T2 getroffen werden. Um den Kondensator C9 als Energiespeicher während der Schaltphase nicht unnötig stark zu entladen, ist der Widerstand R27 relativ hochohmig. Um dennoch ein schnelles Ausschalten im Fehlerfall zu ermöglichen, wird eine komplementäre Endstufe mit entsprechend verschalteten Transistoren Q11 und Q12 nachgeschaltet. Eine emitterseitig mit der Endstufe verbundene Diode D14 ermöglicht das Parallelschalten der beiden Messschaltungen D3, R27 und D4, R28 (Figur 3).

Überschreitet die Kollektor-Emitter-Spannung des IGBT's T2 ein bestimmtes Potential, so zündet ein Thyristor T6 der Schutzschaltung 44. Hierdurch wird der Transistor Q7 des Impulsgebers (Impulsgeberschaltung) 42 durchgesteuert, womit der Ausschaltvorgang eingeleitet wird. Ein steuerseitig des Thyristors T6 gegen Masse geschalteter Kondensator C7 und ein diesem parallel liegender Widerstand R31 bilden einen Filter, um unter anderem ein Auslösen der Schutzschaltung 44 während der Einschaltphase des IGBT's T2 zu verhindern. Die Auslösespannung lässt sich mit folgender Formel ermitteln. ${U}_{CE} \left(T2\right) \geq {U}_{BE} \left(Q12\right) + {U}_{D} \left(D14\right) + {U}_{Z} \left(D13\right) + {U}_{zü} \left(T6\right) - {U}_{D} \left(D3\right) ,$ wobei U_{CE} die Kollektor-Emitter-Spannung, U_{BE} die Basis-Emitter-Spannung, U_{D} die Durchlassspannung, U_{Z} die Zenerspannung und U_{zü} die Zündspannung ist.

Die Figuren 3 und 7 zeigen den Schaltungsaufbau des Netzteils 46 der Trennvorrichtung 30. Das Netzteil 46 dient zum Laden des Kondensators C9 als Energiespeicher und zum Schutz vor einer Schaltüberspannung. Zwischen den Schalter- oder Kontaktanschlüssen J1 und J2 befindet sich der mechanische Schalter 38 (Fig. 2). Sobald der Schalter 38 den Stromkreis öffnet, bildet sich der Lichtbogen LB. Die Lichtbogenspannung wird über in Strompfade 40a und 6b der Halbleiterschalter (Leistungsschalter) T1 und T2 der Leistungselektronik 40 geschaltete Dioden D1, D2 und die Freilaufdioden der IGBT's T1 bzw. T2 gleichgerichtet.

Das Netzteil 46 umfasst einen Halbleiterschalter in Form eines IGBT's T7, dessen Gate über Widerstände R33 bis R37 geladen wird. Sobald das Gate-Emitter-Potential des Thyristors T7 oberhalb der Threshold-Spannung liegt, steuert der IGBT T7 durch und der Kondensator C9 wird geladen. Mit dem IGBT T7 ist ein NPN-Transistor Q15 in der in Figur 7 gezeigten Weise verschaltet. Emitterseitig ist der Transistor Q15 über eine Zenerdiode D19 gegen Masse geschaltet. Erreicht das Potential des Kondensators C9 den Wert der Zenerdiode D19 zuzüglich der Basis-Emitter-Schwellwert-Spannung des Transistors Q15, so wird dieser leitfähig und begrenzt die Gate-Emitter-Spannung des IGBT T7. Dieser beginnt sodann zu sperren und der Ladestrom des Kondensators C9 wird unterbrochen. Um das Gate des IGBT T7 und den Transistor Q15 vor Überspannung zu schützen, ist Basis-Gate-seitig der Halbleiterschalter T7 und Q15 eine Zenerdiode D19 eingefügt.

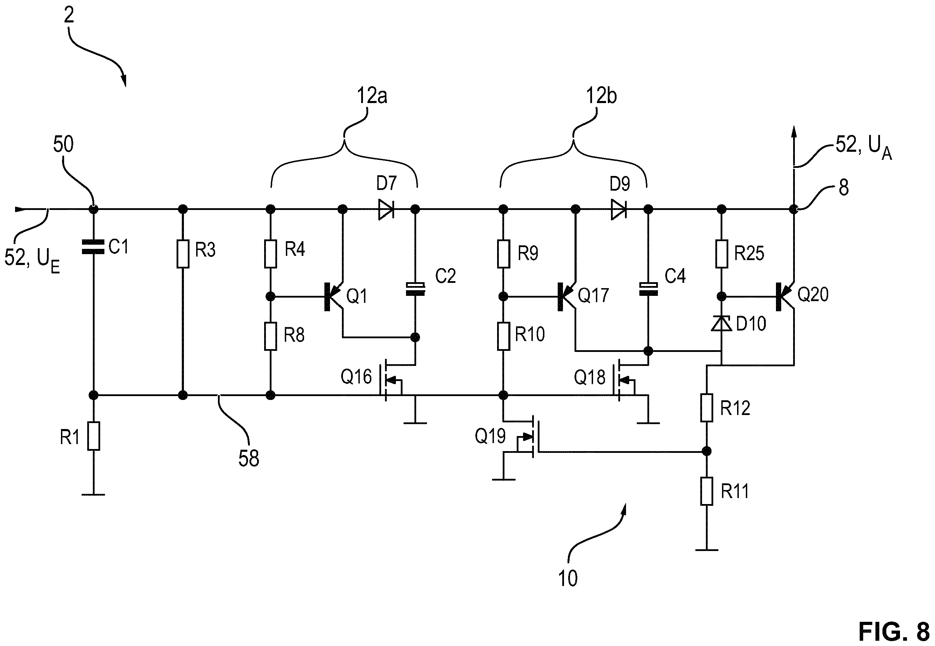

Um die Schaltverzugszeit zum Kurzschließen der Schaltstrecke beziehungsweise zum Verlöschen des Lichtbogens LB zu reduzieren ist dem Netzteil 46 in der Verbindung 52 der in Fig. 8 gezeigte Spannungsvervielfacher 2 nachgeschaltet. Mit dem Spannungsvervielfacher 2 ist es beispielsweise möglich eine 5 V Speise- oder Eingangsspannung, welche nicht ausreichend ist, um einen Steuerimpuls P zu erzeugen mittels welchem die IGBT's T1 und T2 sicher ansteuerbar sind, in eine Ausgangsspannung von 15 V - welche eine sichere Ansteuerung der IGBTs T1 und T2 ermöglicht - zu wandeln.

Der Spannungsvervielfacher 2 ist zwischen dem Klemmenanschluss 50 und dem Abgriffpunkt 8 in die Verbindung 52 geschaltet und weist in dieser Ausführungsform zwei Spannungsstufen 12a und 12b auf. An dem Klemmenanschluss 50 ist ein Kondensator C1 der Steuereinheit 10 angeschlossen, welcher mittels eines Widerstands R1 gegen Masse (Bezugspotential) geführt ist. Die Steuereinheit 10 ist in dieser Ausführung rein schaltungstechnisch ausgeführt. Zwischen den Kondensator C1 und den Widerstand R1 ist hierzu eine Signalverbindung 58 angeschlossen, mittels welcher die Spannungsstufen 12a und 12b ansteuerbar sind. Parallel zu dem Kondensator C1 ist ein Widerstand R3 zwischen die Verbindungen 52 und 58 geschaltet.

Die Spannungsstufe 12a umfasst eine (Gleichrichter-)Diode D7, welche in Reihe mit einem (Lade-)Kondensator C2 und mit einem als MOS-FET ausgeführten Transistors Q16 gegen Masse geschaltet ist. Parallel zu der Diode D7 und dem Kondensator C2 ist ein bipolarer PNP-Transistor Q1 geschaltet, welcher ansteuerseitig an einen Abgriffpunkt eines Spannungsteilers 60a geführt ist, der durch die zwischen den Verbindungen 52 und 58 geschalteten Widerstände R4 und R8 gebildet ist.

Die Spannungsstufe 12b weist entsprechend eine Reihenschaltung einer Diode D9, eines Kondensators C4 und eines Transistors Q18 auf. Parallel zu der Diode D9 und dem Kondensator C4 ist ein Transistor Q17 geschaltet, welcher mittels zweier Widerstände R9 und R10 als Spannungsteiler 60b angesteuert wird.

Die Steuereinheit 10 umfasst in diesem Ausführungsbeispiel einen Widerstand R25 und eine Zenerdiode D10, welche dem Kondensator C4 in der in Fig. 8 dargestellten Weise parallel geschaltet sind. Zwischen der Zenerdiode D10 und dem Widerstand R25 ist der Steuereingang eines bipolaren PNP-Transistors Q20 kontaktiert, welcher emitterseitig an den Abgriffpunkt 8 und kollektorseitig mittels zwei Widerständen R12 und R11 gegen Masse geführt ist. Zwischen den Widerständen R12 und R11 ist ein Gateanschluss eines als MOS-FET ausgeführten Transistors Q19 angeschlossen. Der Transistor Q19 ist sourceseitig gegen Masse geführt und mittels des Drainanschlusses an die Signalleitung 58 angebunden, wobei der Drainanschluss zwischen dem Gateanschluss des Transistors Q18 und dem Sourceanschluss des Transistors 16 kontaktiert ist.

Zu Beginn sind die Kondensatoren C1 und C2 sowie C4 ungeladen und die Transistoren Q16 und Q18 sowie Q1 und Q17 sind in einem elektrisch nicht leitenden Zustand. Wird durch das Netzteil 46 eine Eingangsspannung an den Klemmenanschluss 50 angelegt, fließt ein Strom durch den Kondensator C1. Dadurch werden die Gates der Transistoren Q16 und Q18 aufgeladen. In der Folge schalten die Transistoren Q16 und Q18 durch, wodurch der Kondensator C2 über die Diode D7 und der Kondensator C4 über die Dioden D7 und D9 mit einer jeweiligen Einzelspannung aufgeladen werden.

Erreicht die Einzelspannung oder Ladespannung des Kondensators C4 der Spannungsstufe 12b einen vorgegeben Wert, ermöglicht die Zenerdiode D10 einen Stromfluss durch den Widerstand R25. Steigt der Spannungsfall über den Widerstand R25 auf beispielsweise 0,7 V, schaltet der Transistor Q20 durch. Dadurch wird eine Spannung an das Gate des Transistors Q19 angelegt, welche durch den durch die Widerstände R12 und R11 gebildeten Spannungsteiler begrenzt wird. Somit schaltet der Transistor Q19 durch und zieht die Gates der Transistoren Q16 und Q18 auf Masse, wodurch diese sperrend geschaltet werden und der Ladevorgang der Kondensatoren C2 und C4 beendet wird.

In Folge des durchgeschalteten Transistors Q19 fließt ein elektrischer Strom durch die Reihenschaltungen der Widerstände R4 und R8 sowie der Widerstände R9 und R10 beziehungsweise durch die Spannungsteiler 60a und 60b. Aufgrund der Spannungsabfälle über die Widerstände R4 und R9 werden die PNP-Transistoren Q1 und Q17 durchgeschaltet. Ein Entladen der Kondensatoren C2 und C4 wird hierbei mittels der Dioden D7 und D9 verhindert. Somit werden die Kondensatoren C2 und C4 entlang der Verbindung 52 effektiv in Reihe geschaltet. Dadurch wird an dem Abgriffpunkt 8 eine Ausgangsspannung erzeugt, welche sich aus der Eingangsspannung am Klemmenanschluss 50 zuzüglich der Lade- oder Einzelspannungen der Kondensatoren C2 und C4 zusammensetzt.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

### Bezugszeichenliste

- 2: Spannungsvervielfacher
- 4: Klemmenanschluss/Pluspol
- 6: Klemmenanschluss/Minuspol
- 8: Abgriffpunkt
- 10: Steuereinheit
- 12, 12a, 12b: Spannungsstufe
- 14: Leitung
- 16: Reihenschaltung
- 18: Gleichrichterdiode
- 20: Ladekondensator
- 22, 24: Halbleiterschalter
- 26, 28: Signalleitung
- 30: Trennvorrichtung
- 32: Gleichstromquelle/Photovoltaikgenerator
- 34: Einrichtung/Wechselrichter
- 36: Hauptstrompfad
- 38: Schaltkontakt/Schalter
- 40: Leistungselektronik
- 42: Impulsgeber
- 44: Schutzschaltung
- 46: Netzteil
- 48: Rückführleitung
- 50: Klemmenanschluss
- 52: Verbindung
- 54: Spannungsabgriff
- 56: Treiberstufe
- 58: Signalverbindung
- 60a, 60b: Spannungsteiler

- U_{E}: Eingangsspannung
- U_{A}: Ausgangsspannung
- U_{G}: Bezugspotential
- U_{Z}: Einzelspannung
- LB: Lichtbogen
- J1, J2: Schalteranschluss
- P: Steuerimpuls

## Patentansprüche

1. Verfahren zur Wandlung einer Eingangsspannung (U_{E}) in eine gegenüber dieser erhöhten Ausgangsspannung (U_{A}) mittels einer Anzahl von Spannungsstufen (12, 12a, 12b), welche jeweils eine gegen ein Bezugspotential (U_{G}) geschaltete Reihenschaltung (16) einer Gleichrichterdiode (18, D7, D9) und eines Ladekondensators (20, C2, C4) sowie eines schaltbaren ersten Halbleiterschalters (22, Q16, Q18) aufweist, wobei in jeder Spannungsstufe (12, 12a, 12b) ein schaltbarer zweiter Halbleiterschalter (24, Q1, Q17) parallel zu der Gleichrichterdiode (18, D7, D9) und dem Ladekondensators (20, C2, C4) geschaltet ist, wobei die Gleichrichterdioden (18, D7, D9) benachbarter Spannungsstufen (12, 12a, 12b) in Reihe geschaltet sind,
- bei welchem zunächst die ersten Halbleiterschalter (22, Q16, Q18) geschlossen und die zweiten Halbleiterschalter (24, Q1, Q17) geöffnet werden, so dass die Ladekondensatoren (20, C2, C4) der Spannungsstufen (12, 12a, 12b) mittels der Eingangsspannung (U_{E}) aufgeladen werden, und
- bei welchem anschließend die ersten Halbleiterschalter (22, Q16, Q18) geöffnet und die zweiten Halbleiterschalter (24, Q1, Q17) geschlossen werden, so dass sich die an den Ladekondensatoren (20, C2, C4) erzeugten Einzelspannungen (Uz) entlang der in Reihe geschalteten Gleichrichterdioden (18, D7, D9) zu der Ausgangsspannung (U_{A}) addieren,
**dadurch gekennzeichnet dass**,
dem Ladekondensator (20, C2, C4) und dem zweiten Halbleiterschalter (24, Q1, Q17) der ausgangsseitig letzten Spannungsstufe (12b) eine Zenerdiode (D10) einer Steuereinheit (10) parallel geschaltet ist, welche bei einem geladenen Ladekondensator (20, C2, C4) einen dritten Halbleiterschalter (Q20) derart ansteuert, dass die ersten Halbleiterschalter (22, Q16, Q18) der Spannungsstufen (12, 12a, 12b) öffnen.

2. Spannungsvervielfacher (2) zur Durchführung des Verfahrens gemäß Anspruch 1, insbesondere für eine Trennvorrichtung (30) zur Gleichstromunterbrechung, mit einer Steuereinheit (10), welche mindestens eine Spannungsstufe (12, 12a, 12b) ansteuert, die eine Einzelspannung (U_{Z}) bereitstellt,
- wobei jede Spannungsstufe (12, 12a, 12b) eine gegen ein Bezugspotential (U_{G}) geschaltete Reihenschaltung (16) einer Gleichrichterdiode (18, D7, D9) und eines Ladekondensators (20, C2, C4) sowie eines mittels der Steuereinheit (10) schaltbaren ersten Halbleiterschalters (22, Q16, Q18) aufweist,
- wobei in jeder Spannungsstufe (12, 12a, 12b) ein mittels der Steuereinheit (10) schaltbare zweiter Halbleiterschalter (24, Q1, Q17) parallel zu der Gleichrichterdiode (18, D7, D9) und dem Ladekondensator (20, C2, C4) geschaltet ist,
- wobei die Gleichrichterdioden (18, D7, D9) benachbarter Spannungsstufen (12, 12a, 12b) in Reihe geschaltet sind,
**dadurch gekennzeichnet dass**
dem Ladekondensator (20, C4) und dem zweiten Halbleiterschalter (24, Q17) der ausgangsseitig letzten Spannungsstufe (12, 12b) eine Zenerdiode (D10) der Steuereinheit (10) parallel geschaltet ist, welche bei einem geladenen Ladekondensator (20, C4) einen dritten Halbleiterschalter (Q20) derart ansteuert, dass die ersten Halbleiterschalter (22, Q16, Q18) der Spannungsstufen (12, 12a, 12b) öffnen.

3. Spannungsvervielfacher (2) nach Anspruch 2,
**dadurch gekennzeichnet,**
**dass** den Spannungsstufen (12, 12a, 12b) eingangsseitig ein Kondensator (C1) der Steuereinheit (10) vorgeschalten ist, welcher im geladenen Zustand die ersten Halbleiterschalter (22, Q16, Q18) der Spannungsstufen (12, 12a, 12b) schließend ansteuert.

4. Spannungsvervielfacher (2) nach Anspruch 2 oder 3,
**dadurch gekennzeichnet,**
**dass** zur Ansteuerung des zweiten Halbleiterschalters (24, Q1, Q17) der jeweiligen Spannungsstufe (12, 12a, 12b) ein der Reihenschaltung (16) parallel geschalteter Spannungsteiler (60a, 60b) vorgesehen ist.

5. Spannungsvervielfacher (2) nach einem der Ansprüche 2 bis 4,
**dadurch gekennzeichnet,**
- **dass** der erste Halbleiterschalter (22, Q16, Q18) als ein MOS-FET ausgeführt ist, welcher drainseitig an den Ladekondensator (20, C2, C4) und sourceseitig an das Bezugspotential (U_{G}) geführt ist, und
- **dass** der zweite Halbleiterschalter (24, Q1, Q17) als ein Bipolartransistor ausgeführt ist, welcher entlang der Kollektor-Emitter-Strecke der Gleichrichterdiode (18, D7, D9) und dem Ladekondensator (20, C2, C4) parallel geschaltet ist und basisseitig an einen Gateanschluss des ersten Halbleiterschalters (22, Q16, Q18) geführt ist.

6. Trennvorrichtung (30) zur Gleichstromunterbrechung zwischen einer Gleichstromquelle (32) und einer elektrischen Einrichtung (34), mit einem stromführenden mechanischen Schalter (38) und mit einer mit diesem verschalteten Leistungselektronik (40) sowie mit einem Netzteil (46), dessen Aufladung mittels einer bei öffnendem Schalter (38) an diesem infolge eines Lichtbogens (LB) erzeugten Lichtbogenspannung erfolgt, wobei ein mit dem Netzteil (46) verbundener Impulsgeber (42), welcher mindestens einen Halbleiterschalter (T1, T2) der Leistungselektronik (40) derart ansteuert, dass diese den Schalter (38) unter Verlöschen des Lichtbogens (LB) kurzschließt, wobei zwischen dem Netzteil (46) und dem Impulsgeber (42) ein Spannungsvervielfacher (2) gemäß einem der Ansprüche 2 bis 5 verschaltet ist.

7. Trennvorrichtung (30) nach Anspruch 6,
**dadurch gekennzeichnet,**
**dass** der Spannungsvervielfacher (2) eingangsseitig mit einem Energiespeicher (C9) des Netzteils (46) verbunden ist.

8. Trennvorrichtung (30) nach Anspruch 6 oder 7,
**dadurch gekennzeichnet,**
**dass** der Impulsgeber (42) einen mit dem Ausgang (8) des Spannungsvervielfachers (2) verbundenen und einem Spannungsabgriff (54) vorgeschalteten Halbleiterschalter (T4) umfasst, welcher leitend gesteuert ist, wenn die Ausgangsspannung (U_{A}) des Spannungsvervielfachers (2) eine eingestellte oder einstellbare Betriebsspannung erreicht.

9. Trennvorrichtung (30) nach Anspruch 8,
**dadurch gekennzeichnet,**
**dass** die Leistungselektronik (40) ansteuerseitig einen aus der Ausgangsspannung (U_{A}) des Spannungsvervielfachers (2) generierten Steuerimpuls (P) am Spannungsabgriff (54) des Impulsgebers (42) abgreift.

## Claims

1. Method for converting an input voltage (U_{E}) into an output voltage (U_{A}), which is increased in comparison to said input voltage (U_{E}), by means of a number of voltage stages (12, 12a, 12b), each of which comprises a series circuit (16) of a rectifier diode (18, D7, D9) and a charging capacitor (20, C2, C4) as well as a switchable first semiconductor switch (22, Q16, Q18), each of said series circuits (16) being connected to a reference potential (U_{G}), wherein in each voltage stage (12, 12a, 12b) a switchable second semiconductor switch (24, Q1, Q17) is connected in parallel with the rectifier diode (18, D7, D9) and the charging capacitor (20, C2, C4), wherein the rectifier diodes (18, D7, D9) of adjacent voltage stages (12, 12a, 12b) are connected in series,
- in which firstly the first semiconductor switches (22, Q16, Q18) are closed and the second semiconductor switches (24, Q1, Q17) are opened, so that the charging capacitors (20, C2, C4) of the voltage stages (12, 12a, 12b) are charged by means of the input voltage (U_{E}), and
- in which subsequently the first semiconductor switches (22, Q16, Q18) are opened and the second semiconductor switches (24, Q1, Q17) are closed, so that the individual voltages (U_{Z}) generated at the charging capacitors (20, C2, C4) sum over the series-connected rectifier diodes (18, D7, D9) to produce the output voltage (U_{A}),
**characterized in that**
a Zener diode (D10) of a control unit (10) is connected in parallel with the charging capacitor (20, C2, C4) and the second semiconductor switch (24, Q1, Q17) of the last voltage stage (12b) on the output side, said Zener diode controlling a third semiconductor switch (Q20) in the case of a charged charging capacitor (20, C2, C4) in such a way that the first semiconductor switches (22, Q16, Q18) of the voltage stages (12, 12a, 12b) open.

2. Voltage multiplier (2) for carrying out the method according to claim 1, in particular for a disconnecting device (30) for interrupting direct current, with a control unit (10), which controls at least one voltage stage (12, 12a, 12b) that provides an individual voltage (U_{Z}),
- wherein each voltage stage (12, 12a, 12b) comprises a series circuit (16) of a rectifier diode (18, D7, D9) and a charging capacitor (20, C2, C4) as well as a first semiconductor switch (22, Q16, Q18), said series circuit being connected to a reference potential (U_{G}) and being switchable by means of the control unit (10),
- wherein in each voltage stage (12, 12a, 12b) a second semiconductor switch (24, Q1, Q17) switchable by means of the control unit (10) is connected in parallel with the rectifier diode (18, D7, D9) and the charging capacitor (20, C2, C4),
- wherein the rectifier diodes (18, D7, D9) of adjacent voltage stages (12, 12a, 12b) are connected in series,
**characterized in that**
a Zener diode (D10) of the control unit (10) is connected in parallel with the charging capacitor (20, C4) and the second semiconductor switch (24, Q17) of the last voltage stage (12, 12b) on the output side, said Zener diode (D10) controlling a third semiconductor switch (Q20) in the case of a charged charging capacitor (20, C4) in such a way that the first semiconductor switches (22, Q16, Q18) of the voltage stages (12, 12a, 12b) open.

3. Voltage multiplier (2) according to claim 2,
**characterized in**
**that** a capacitor (C1) of the control unit (10) is connected upstream of the voltage stages (12, 12a, 12b) on the input side, said capacitor (C1) in the charged state closing the first semiconductor switches (22, Q16, Q18) of the voltage stages (12, 12a, 12b).

4. Voltage multiplier (2) according to claim 2 or 3,
**characterized in**
**that** a voltage divider (60a, 60b) connected in parallel with the series circuit (16) is provided for controlling the second semiconductor switch (24, Q1, Q17) of the respective voltage stage (12, 12a, 12b).

5. Voltage multiplier (2) according to one of claims 2 to 4,
**characterized in**
- **that** the first semiconductor switch (22, Q16, Q18) is designed as a MOS-FET, which is connected on the drain side to the charging capacitor (20, C2, C4) and on the source side to the reference potential (U_{G}), and
- **that** the second semiconductor switch (24, Q1, Q17) is designed as a bipolar transistor, which is connected in parallel along the collector-emitter path of the rectifier diode (18, D7, D9) and the charging capacitor (20, C2, C4) and is led on the base side to a gate terminal of the first semiconductor switch (22, Q16, Q18).

6. Disconnecting device (30) for interrupting direct current between a DC source (32) and an electrical device (34), with a current-carrying mechanical switch (38) and with power electronics (40) connected to said switch (38) and with a power supply unit (46), which is charged by means of an arc voltage generated at the switch (38) as a result of an arc (LB) when the switch (38) opens, wherein a pulse generator (42) connected to the power supply unit (46) controls at least one semiconductor switch (T1, T2) of the power electronics (40) in such a way that the power electronics short-circuits the switch (38) while extinguishing the arc (LB), wherein a voltage multiplier (2) according to one of claims 2 to 5 is connected between the power supply unit (46) and the pulse generator (42).

7. Disconnecting device (30) according to claim 6,
**characterized in**
**that** the voltage multiplier (2) on the input side is connected to an energy store (C9) of the power supply unit (46).

8. Disconnecting device (30) according to claim 6 or 7,
**characterized in**
**that** the pulse generator (42) comprises a semiconductor switch (T4), which is connected to the output (8) of the voltage multiplier (2) and is connected upstream of a voltage tap (54) and is controlled to be conductive when the output voltage (U_{A}) of the voltage multiplier (2) reaches an adjusted or adjustable operating voltage.

9. Disconnecting device (30) according to claim 8,
**characterized in**
**that** the power electronics (40) on the control side taps a control pulse (P) generated from the output voltage (U_{A}) of the voltage multiplier (2) at the voltage tap (54) of the pulse generator (42).

## Revendications

1. Procédé pour convertir une tension d'entrée (U_{E}) en une tension de sortie (U_{A}), qui est augmentée par rapport à ladite tension d'entrée (U_{E}), au moyen d'un nombre d'étages de tension (12, 12a, 12b), dont chacun comprend un circuit série (16), d'une diode redresseuse (18, D7, D9) et d'un condensateur de charge (20, C2, C4) ainsi qu'un premier commutateur à semi-conducteur commutable (22, Q16, Q18), ledit circuit série (16) étant connecté à un potentiel de référence (U_{G}), dans lequel dans chaque étage de tension (12, 12a, 12b), un deuxième commutateur à semi-conducteur commutable (24, Q1, Q17) est connecté en parallèle avec la diode de redressement (18, D7, D9) et le condensateur de charge (20, C2, C4), dans lequel les diodes de redressement (18, D7, D9) d'étages de tension adjacents (12, 12a, 12b) sont connectées en série,
- dans lequel, d'une part, les premiers commutateurs à semi-conducteur (22, Q16, Q18) sont fermés et les deuxièmes commutateurs à semi-conducteur (24, Q1, Q17) sont ouverts, de sorte que les condensateurs de charge (20, C2, C4) des étages de tension (12, 12a, 12b) sont chargés au moyen de la tension d'entrée (U_{E}), et
- dans lequel, ensuite, les premiers commutateurs à semi-conducteur (22, Q16, Q18) sont ouverts et les deuxièmes commutateurs à semi-conducteur (24, Q1, Q17) sont fermés, de sorte que les tensions individuelles (U_{Z}) générées au niveau des condensateurs de charge (20, C2, C4) s'additionnent le long des diodes redresseuses montées en série (18, D7, D9) pour produire la tension de sortie (U_{A})
**caractérisé en ce**
**qu'**une diode Zener (D10) d'une unité de commande (10) est montée en parallèle avec le condensateur de charge (20, C2, C4) et le deuxième commutateur à semi-conducteur (24, Q1, Q17) du dernier étage de tension (12b) du côté de la sortie, ladite diode Zener commandant un troisième commutateur à semi-conducteur (Q20) dans le cas d'un condensateur de charge chargé (20, C2, C4) de telle sorte que les premiers commutateurs à semi-conducteur (22, Q16, Q18) des étages de tension (12, 12a, 12b) s'ouvrent.

2. Multiplicateur de tension (2) pour la mise en oeuvre du procédé selon la revendication 1, en particulier pour un dispositif de coupure (30) pour l'interruption du courant continu, avec une unité de commande (10) qui commande au moins un étage de tension (12, 12a, 12b) qui fournit une tension individuelle (U_{Z}),
- dans lequel chaque étage de tension (12, 12a, 12b) comprend un circuit série (16) d'une diode redresseuse (18, D7, D9) et d'un condensateur de charge (20, C2, C4) ainsi d'un premier commutateur à semi-conducteur (22, Q16, Q18), ledit circuit série (16) étant connecté à un potentiel de référence (U_{G}) et étant commutable au moyen de l'unité de commande (10),
- dans lequel, dans chaque étage de tension (12, 12a, 12b), un deuxième commutateur à semi-conducteur (24, Q1, Q17) commutable au moyen de l'unité de commande (10) est connecté en parallèle avec la diode de redressement (18, D7, D9) et le condensateur de charge (20, C2, C4),
- dans lequel les diodes de redressement (18, D7, D9) des étages de tension adjacents (12, 12a, 12b) sont connectées en série,
**caractérisé en ce que**
une diode Zener (D10) de l'unité de commande (10) est montée en parallèle avec le condensateur de charge (20, C4) et le deuxième commutateur à semi-conducteur (24, Q17) du dernier étage de tension (12, 12b) du côté de la sortie, cette diode Zener (D10) commandant un troisième commutateur à semi-conducteurs (Q20) dans le cas d'un condensateur de charge chargé (20, C4) de telle sorte que les premiers commutateurs à semi-conducteurs (22, Q16, Q18) des étages de tension (12, 12a, 12b) s'ouvrent.

3. Multiplicateur de tension (2) selon la revendication 2,
**caractérisé en ce**
**qu'**un condensateur (C1) de l'unité de commande (10) est connecté en amont des étages de tension (12, 12a, 12b) du côté de l'entrée, ledit condensateur (C1) à l'état chargé fermant les premiers commutateurs à semi-conducteurs (22, Q16, Q18) des étages de tension (12, 12a, 12b).

4. Multiplicateur de tension (2) selon la revendication 2 ou 3,
**caractérisé en ce**
**qu'**un diviseur de tension (60a, 60b) monté en parallèle avec le circuit série (16) est prévu pour commander le deuxième commutateur à semi-conducteur (24, Q1, Q17) de l'étage de tension respectif (12, 12a, 12b).

5. Multiplicateur de tension (2) selon l'une des revendications 2 à 4,
**caractérisé en ce**
- **que** le premier commutateur à semi-conducteur (22, Q16, Q18) est conçu comme un MOS-FET, qui est connecté du côté du drain au condensateur de charge (20, C2, C4) et du côté de la source au potentiel de référence (U_{G}), et
- **que** le deuxième commutateur à semi-conducteur (24, Q1, Q17) est conçu comme un transistor bipolaire, qui est connecté en parallèle le long du trajet collecteur-émetteur de la diode de redressement (18, D7, D9) et du condensateur de charge (20, C2, C4) et qui est conduit du côté de la base à une borne de grille du premier commutateur à semi-conducteurs (22, Q16, Q18).

6. Dispositif de coupure (30) pour l'interruption du courant continu entre une source de courant continu (32) et un appareil électrique (34), avec un interrupteur mécanique (38) conduisant le courant et avec une électronique de puissance (40) connectée audit interrupteur mécanique (38), et avec un bloc d'alimentation (46), dont la charge se fait au moyen d'une tension d'arc produite au niveau de l'interrupteur (38) par un arc électrique (LB) lors de l'ouverture de l'interrupteur (38), dans lequel un générateur d'impulsions (42) connecté au bloc d'alimentation (46) commande au moins un commutateur à semi-conducteurs (T1, T2) de l'électronique de puissance (40) de telle sorte que l'électronique de puissance court-circuite l'interrupteur (38) en éteignant l'arc électrique (LB), dans lequel un multiplicateur de tension (2) selon l'une des revendications 2 à 5 est connecté entre le bloc d'alimentation (46) et le générateur d'impulsions (42).

7. Dispositif de coupure (30) selon la revendication 6,
**caractérisé en ce**
**que** le multiplicateur de tension (2) du côté de l'entrée est connecté à un réservoir d'énergie (C9) du bloc d'alimentation (46).

8. Dispositif de séparation (30) selon la revendication 6 ou 7,
**caractérisé en ce**
**que** le générateur d'impulsions (42) comprend un commutateur à semi-conducteur (T4), qui est connecté à la sortie (8) du multiplicateur de tension (2) et est branché en amont d'une prise de tension (54) et est commandé pour être conducteur lorsque la tension de sortie (U_{A}) du multiplicateur de tension (2) atteint une tension de fonctionnement réglée ou réglable.

9. Dispositif de déconnexion (30) selon la revendication 8,
**caractérisé en ce**
**que** l'électronique de puissance (40) du côté de la commande prend une impulsion de commande (P) générée à partir de la tension de sortie (U_{A}) du multiplicateur de tension (2) à la prise de tension (54) du générateur d'impulsions (42).
